# FASCICULE DE BREVET EUROPEEN

(11) **EP 4 004 507 B1**
(45) Date de publication et mention de la délivrance du brevet: **25.09.2024**
(21) Numéro de dépôt: 20749831.2
(22) Date de dépôt: 27.07.2020
(51) Int. Cl.: G01J 5/04, G01J 5/20

(54) **PROCEDE DE FABRICATION D'UN MICROBOLOMETRE COMPORTANT UN MATERIAU SENSIBLE A BASE D'OXYDE DE VANADIUM**
VERFAHREN ZUR HERSTELLUNG EINES MIKROBOLOMETERS MIT EINEM EMPFINDLICHEN MATERIAL AUF BASIS VON VANADIUMOXID
PROCESS FOR PRODUCING A MICROBOLOMETER COMPRISING A VANADIUM-OXIDE-BASED SENSITIVE MATERIAL

(30) Priorité: 30.07.2019 FR 1908688
(43) Date de publication de la demande: 01.06.2022
(73) Titulaire: Commissariat à l'Energie Atomique et aux Energies Alternatives, 75015 Paris (FR); LYNRED, 91120 Palaiseau (FR)
(72) Inventeur: PELENC, Denis, 38054 GRENOBLE Cedex 09 (FR); BADANO, Giacomo, 38054 GRENOBLE Cedex 09 (FR); CARDOSO, Alexi, 38054 Veurey-Voroize (FR); GUILLAUMONT, Marc, 38054 Veurey-Voroize (FR)
(74) Mandataire: Brevalex
(86) Numéro de dépôt international: PCT/EP2020/071170
(87) Numéro de publication internationale: WO 2021/018856

(56) Documents cités:
- WO-A1-2011/096012
- KR-B1- 101 439 263
- US-A1- 2014 159 032

## Description

### DOMAINE TECHNIQUE

Le domaine de l'invention est celui des dispositifs de détection d'un rayonnement électromagnétique, par exemple infrarouge ou térahertz, comportant au moins un détecteur thermique résistif comprenant un matériau sensible à base d'oxyde de vanadium. L'invention s'applique notamment au domaine de l'imagerie infrarouge et de la thermographie.

### ÉTAT DE LA TECHNIQUE ANTÉRIEURE

Un dispositif de détection de rayonnement électromagnétique peut comporter une matrice de détecteurs thermiques résistifs, également appelés microbolomètres, chaque microbolomètre comportant une portion absorbante apte à absorber le rayonnement électromagnétique à détecter.

Dans le but d'assurer l'isolation thermique du matériau sensible des microbolomètres, les portions absorbantes se présentent habituellement sous la forme de membranes suspendues au-dessus du substrat par des piliers d'ancrage, et sont isolées thermiquement de celui-ci par des bras de maintien et d'isolation thermique. Ces piliers d'ancrage et bras d'isolation thermique présentent également une fonction électrique en reliant électriquement les membranes suspendues à un circuit de lecture généralement disposé dans le substrat.

La membrane absorbante comporte un matériau sensible dont la résistivité électrique p varie en fonction de la température du matériau. Le matériau sensible est caractérisé par la valeur ρₐ de la résistivité électrique à température ambiante ainsi que par son coefficient a (ou TCR), lequel est défini par la relation a = 1/ρ × dp/dT. Le matériau sensible peut être un matériau semiconducteur choisi habituellement parmi le silicium amorphe et un oxyde de vanadium VOₓ.

Le choix du matériau sensible dépend notamment de sa compatibilité avec les étapes classiques de dépôt et de gravure habituellement utilisées dans la microélectronique, et notamment dans la technologie silicium. Cependant, il apparaît qu'un matériau sensible à base d'oxyde de vanadium est susceptible de voir ses propriétés électriques dégradées à la suite du procédé de fabrication du microbolomètre.

Le document KR101439263B1 divulgue un exemple de procédé de fabrication d'un matériau sensible pour microbolomètre.

### EXPOSÉ DE L'INVENTION

L'invention a pour objectif de remédier au moins en partie aux inconvénients de l'art antérieur, et plus particulièrement de proposer un procédé de fabrication d'au moins un microbolomètre comportant un matériau sensible à base d'oxyde de vanadium dont les propriétés électriques sont préservées au cours du procédé de fabrication, et plus précisément dont les risques de dégradation du bruit en 1/f du matériau sensible, à la suite du procédé de fabrication, sont limités voire écartés.

Pour cela, l'objet de l'invention est un procédé de fabrication d'au moins un microbolomètre comportant un matériau sensible, le procédé permettant de limiter une dégradation d'un bruit associé audit matériau sensible. Le matériau sensible est formé : d'un premier composé à base d'oxyde de vanadium (VOₓ) ; et d'au moins un élément chimique additionnel ajouté audit premier composé et choisi parmi l'arsenic (As), le germanium (Ge), le silicium (Si), et le phosphore (P), à l'exception de l'azote (N). Le procédé comporte les étapes suivantes :
- une étape de réalisation dudit matériau sensible en couche mince ;
- une étape d'exposition du matériau sensible à une température Tᵣ supérieure à la température ambiante pendant une durée Δtᵣ, effectuée ultérieurement à l'étape de réalisation du matériau sensible, la température Tᵣ et la durée Δtᵣ étant telles que ledit premier composé, étant amorphe et présentant une valeur native de résistivité électrique à température ambiante comprise entre 1 Ω.cm et 30 Ω.cm, ayant subi une étape d'exposition à la température Tᵣ pendant la durée Δtᵣ, présente une résistivité électrique à température ambiante inférieure ou égale à 10% de sa valeur native.

Le procédé comporte en outre les étapes suivantes :
- détermination d'une quantité dite efficace non nulle de l'élément chimique additionnel (As, Ge, Si, P) ajouté audit premier composé (VOₓ), formant ainsi un composé modifié, à partir de laquelle le composé modifié, ayant subi une étape d'exposition à la température Tᵣ pendant la durée Δtᵣ, présente une résistivité électrique ρ_{a|r} à température ambiante supérieure à 10% de sa valeur native ρₐ ;
- lors de ladite étape de réalisation du matériau sensible en couche mince, celui-ci est formé dudit composé modifié ayant une quantité de l'élément chimique additionnel (As, Ge, Si, P) supérieure ou égale à la quantité efficace préalablement déterminée, le matériau sensible étant amorphe, présentant une valeur native ρₐ de résistivité électrique à température ambiante comprise entre 0.1 Ω.cm et 30 Ω.cm ainsi qu'une composition chimique homogène ;
- de sorte que, à la suite de ladite étape d'exposition du matériau sensible à la température Tᵣ pendant la durée Δtᵣ, ledit matériau sensible présente alors un bruit dont la dégradation a été limitée.

Certains aspects préférés mais non limitatifs de ce procédé de fabrication sont les suivants.

L'élément chimique additionnel est de préférence choisi parmi l'arsenic, le germanium, et le silicium, et est de préférence l'arsenic.

L'étape d'exposition du matériau sensible peut comprendre une étape de dépôt d'une couche de protection recouvrant le matériau sensible.

L'étape d'exposition du matériau sensible peut comprendre une étape de dépôt d'une couche d'encapsulation transparente au rayonnement électromagnétique à détecter destinée à définir une cavité dans laquelle est situé le microbolomètre.

La température Tᵣ est de préférence supérieure ou égale à 330°C, voire égale à 350°C à 5°C près.

La durée Δtᵣ est de préférence supérieure ou égale à 90min.

Le matériau sensible est de préférence réalisé à une température inférieure à la température Tᵣ.

L'invention porte également sur un microbolomètre comportant un matériau sensible formé : d'un premier composé à base d'oxyde de vanadium (VOₓ) ; et d'au moins un élément chimique additionnel choisi parmi l'arsenic, le germanium, le silicium et le phosphore, à l'exception de l'azote. Le matériau sensible est amorphe ; présente une résistivité électrique à température ambiante comprise entre 0.1 Ω.cm et 30 Ω.cm ; présente une composition chimique homogène ; et comporte une quantité de l'élément chimique additionnel, définie comme le rapport du nombre d'atomes l'élément chimique additionnel sur celui de vanadium, au moins égale à 0.012 dans le cas de l'arsenic, au moins égale à 0.04 dans le cas du germanium et du silicium, et au moins égale à 0.12 dans le cas du phosphore.

La quantité d'oxygène, définie comme le rapport du nombre d'atomes d'oxygène sur celui de vanadium, peut être comprise entre 1.42 et 1.94, à plus ou moins 0.05 près.

Le matériau sensible peut être recouvert par une couche de protection en nitrure de silicium.

L'invention porte également sur un dispositif de détection d'un rayonnement électromagnétique, comportant une matrice de microbolomètres selon l'une quelconque des caractéristiques précédentes, les microbolomètres étant disposés dans au moins une cavité hermétique délimitée par une structure d'encapsulation transparente au rayonnement électromagnétique à détecter, la structure d'encapsulation comportant au moins une couche réalisée en silicium amorphe.

Le dispositif de détection peut comporter un matériau getter situé dans la cavité hermétique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, respectivement en perspective et en coupe suivant le plan A-A', d'un microbolomètre selon un mode de réalisation, comportant un matériau sensible à base d'oxyde de vanadium ;
les figures 2A à 2C illustrent, respectivement :
   ∘ un exemple d'évolution, en fonction d'une température Tᵣ d'exposition thermique, de la résistivité électrique à température ambiante d'un composé de base réalisé à partir d'oxyde de vanadium (dit premier composé), ne contenant pas d'élément chimique additionnel choisi parmi l'arsenic, le germanium, le silicium et le phosphore ;
   ∘ un exemple de valeurs du coefficient TCR pour des composés de base VOₓ en fonction de leur résistivité électrique, sans exposition thermique, et après exposition thermique à 310°C pendant 90min ;
   ∘ un exemple de valeurs d'un paramètre représentatif du bruit en 1/f pour des composés de base VOₓ en fonction de leur résistivité électrique, sans exposition thermique, et après exposition thermique à 310°C pendant 90min ;

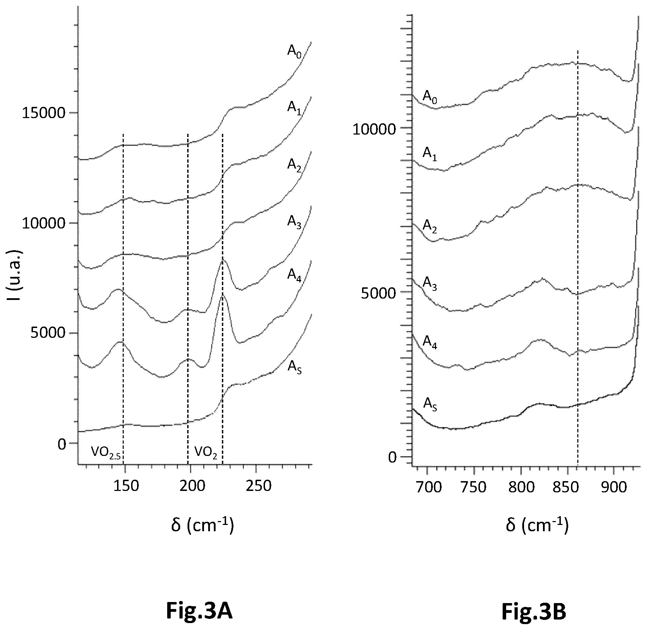

les figures 3A et 3B sont des exemples de spectres Raman pour des composés de base VOₓ sans exposition thermique, et après exposition thermique pendant 90min à différentes températures ;

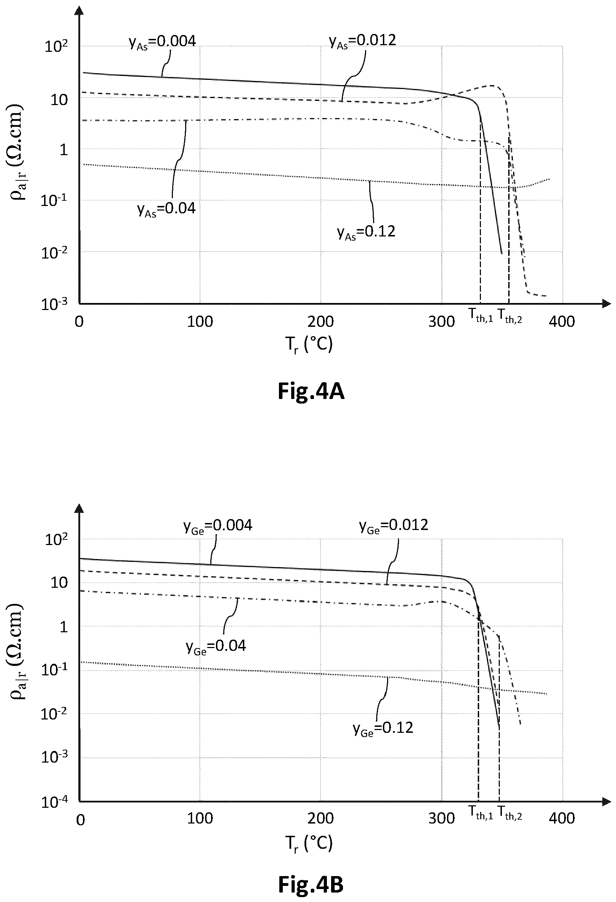

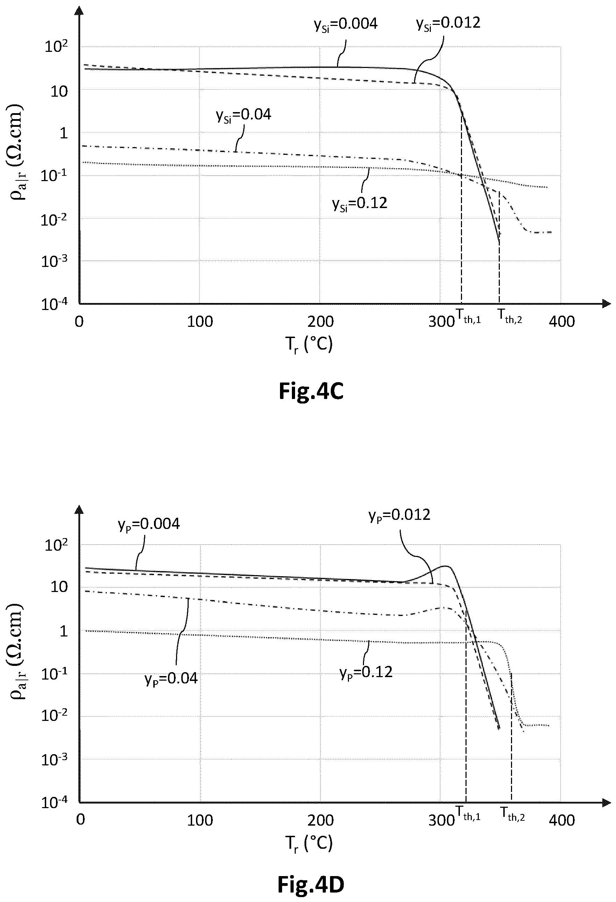

les figures 4A à 4D sont des graphes illustrant l'évolution de la résistivité électrique ρ_{a|r} à température ambiante du matériau sensible à base d'oxyde de vanadium, après exposition dudit matériau à une température Tᵣ pendant une durée Δtᵣ, pour différentes quantités d'un élément chimique additionnel, ce dernier étant l'arsenic (fig.4A), le germanium (fig.4B), le silicium (fig.4C), et le phosphore (fig.4D).

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près, et, en ce qui concerne les températures, à 10°C près et de préférence à 5°C près. Par ailleurs, l'expression « comportant un » doit être comprise comme « comportant au moins un », sauf indication contraire.

Les indications relatives à la composition chimique d'un composé sont exprimées par sa formule chimique brute, exprimée conventionnellement par rapport à un (1) atome de vanadium. Ainsi, pour un composé VOₓAs_{y}, mentionné ici à titre purement illustratif, la valeur x de la quantité d'oxygène est le nombre d'atomes d'oxygène pour 1 atome de vanadium, et la valeur y de la quantité d'arsenic est le nombre d'atomes d'arsenic pour 1 atome de vanadium. La valeur de la quantité de l'élément chimique est donnée à 10% près. Par ailleurs, la proportion atomique de chaque élément chimique dans le composé VOₓAs_{y} est de 1/(1+x+y) pour le vanadium, de x/(1+x+y) pour l'oxygène, et de y/(1+x+y) pour l'arsenic.

L'invention porte notamment sur un procédé de fabrication d'au moins un détecteur thermique résistif, également appelé microbolomètre, comportant un matériau sensible à base d'oxyde de vanadium VOₓ. Le microbolomètre peut être adapté à détecter un rayonnement infrarouge ou térahertz. Le matériau sensible comporte une quantité suffisante non nulle d'au moins un élément chimique additionnel choisi parmi l'arsenic As, le germanium Ge, le silicium Si et le phosphore P, à l'exception de l'azote (N), permettant d'améliorer la stabilité thermique du matériau sensible. Dans la suite de la description, on appelle 'composé de base' un composé à base de VOₓ ne contenant pas l'élément chimique additionnel, et on appelle 'composé modifié' le composé de base dans lequel l'élément chimique additionnel a été ajouté.

Le procédé de fabrication met en oeuvre au moins une étape dans laquelle le matériau sensible est exposé à une température supérieure à la température ambiante, et inférieure ou égale à une température Tᵣ, pendant une durée inférieure ou égale à Δtᵣ, par exemple à 330°C ou à 350°C, voire à 390°C, pendant 10min, 30min, voire 90min ou davantage. La température Tᵣ d'exposition thermique est donc supérieure à la température ambiante.

Cette étape d'exposition thermique peut correspondre au dépôt à 330°C environ d'une couche de protection, par exemple réalisée en un nitrure de silicium SiN ou en un oxyde de silicium SiO, recouvrant le matériau sensible dans le but de le protéger de toute contamination ultérieure par des éléments chimiques éventuellement présents. Elle peut également correspondre à la réalisation d'une couche d'encapsulation en silicium amorphe, ladite couche étant destinée à définir une cavité hermétique dans laquelle est situé le microbolomètre. Il peut également s'agir d'une activation à 330°C environ d'un matériau getter situé dans la cavité hermétique, ce matériau getter étant destiné à réagir avec du gaz résiduel éventuellement présent dans la cavité pour maintenir celle-ci à un niveau de vide suffisant.

Ces exemples sont donnés à titre illustratif. L'étape d'exposition thermique à la température Tᵣ pendant la durée Δtᵣ peut être mise en oeuvre, d'une manière générale, dans le cadre d'étapes technologiques de fabrication du microbolomètre effectuées après la réalisation du matériau sensible, voire dans le cadre d'étapes technologiques de fabrication du dispositif de détection après la réalisation du ou des microbolomètres, notamment pour l'intégration de fonctionnalités additionnelles au niveau de la puce de détection.

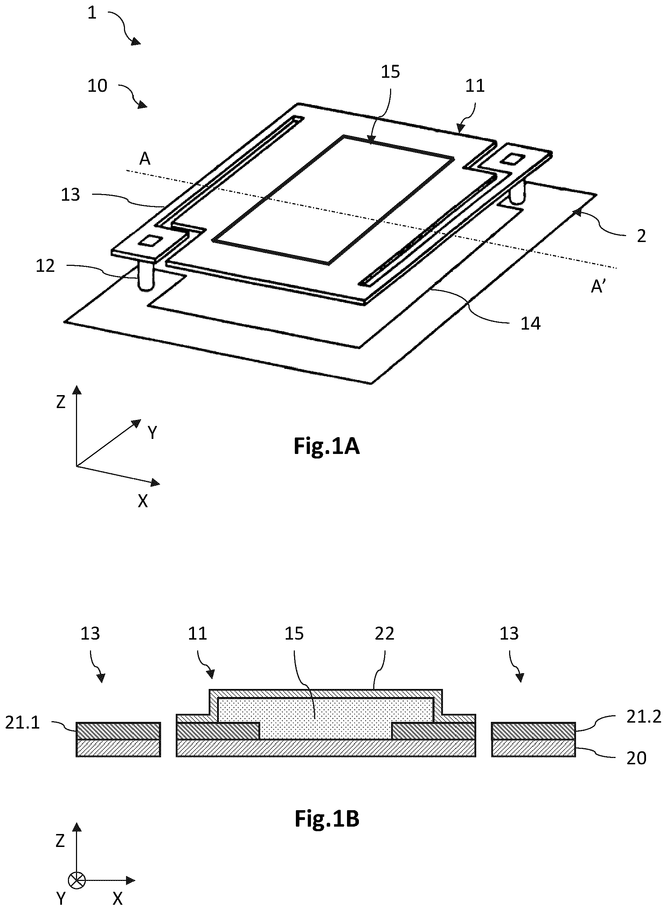

Les figures 1A et 1B sont des vues schématiques et partielles, respectivement en perspective et en coupe suivant le plan A-A', d'un microbolomètre 10 d'un dispositif de détection 1 d'un rayonnement électromagnétique, le microbolomètre 10 comportant un matériau sensible 15 à base d'oxyde de vanadium VOₓ.

Le microbolomètre 10 comporte une membrane absorbante 11 à matériau sensible 15 à base d'oxyde de vanadium VOₓ, suspendue au-dessus d'un substrat 2 par des piliers d'ancrage 12 et des bras d'isolation thermique 13, ainsi qu'un circuit électronique de commande et de lecture (non représenté) situé dans le substrat 2. Le microbolomètre 10 est ici adapté à absorber un rayonnement infrarouge compris dans la bande de longueurs d'onde infrarouges longues (dite LWIR), allant de 8µm à 14µm environ.

On définit ici et pour la suite de la description un repère direct tridimensionnel orthogonal (X,Y,Z), où le plan XY est sensiblement parallèle au plan d'un substrat 2, l'axe Z étant orienté suivant une direction sensiblement orthogonale au plan du substrat 2. Par ailleurs, les termes « inférieur » et « supérieur » s'entendent comme étant relatifs à un positionnement croissant lorsqu'on s'éloigne du substrat 2 suivant la direction +Z.

Le microbolomètre 10 comporte un substrat 2, réalisé dans cet exemple à base de silicium, comportant un circuit électronique (non représenté) permettant la commande et la lecture du microbolomètre. Le circuit électronique comporte des portions de lignes conductrices, par exemple métalliques, séparées les unes des autres par un matériau diélectrique, par exemple un matériau minéral à base de silicium tel qu'un oxyde de silicium SiO, un nitrure de silicium SiN, ou leurs alliages. Il peut comporter à cet effet des éléments électroniques actifs, par exemple des diodes, transistors, condensateurs, résistances..., connectés par des interconnexions électriques au microbolomètre 10 d'une part, et à un plot d'interconnexion (non représenté) d'autre part, ce dernier étant destiné à relier électriquement le dispositif de détection 1 à un dispositif électronique externe.

La face supérieure du substrat 2 peut être revêtue d'une couche de protection (non représentée) notamment lorsque la membrane absorbante est réalisée sur une couche sacrificielle minérale, laquelle est ensuite éliminée par attaque chimique en milieu acide. Elle peut recouvrir ou être recouverte par une couche réflectrice 14 disposée sous la membrane absorbante 11. Lorsqu'elle revêt la couche réflectrice 14, elle est réalisée en un matériau au moins partiellement transparent au rayonnement électromagnétique à détecter. La couche de protection présente une fonction d'arrêt de gravure, et est adaptée à assurer une protection du substrat et des couches diélectriques inter-métal lorsqu'elles sont réalisées en un matériau minéral vis-à-vis d'une attaque chimique, par exemple une attaque chimique en milieu acide HF (acide fluorhydrique) mise en oeuvre ultérieurement pour graver la couche sacrificielle minérale utilisée lors de la réalisation de la membrane absorbante. Cette couche de protection forme ainsi une couche hermétique et chimiquement inerte. Elle est électriquement isolante pour éviter tout court-circuit entre les portions de ligne métallique. Elle peut ainsi être réalisée en alumine Al₂O₃, voire en nitrure ou fluorure d'aluminium. Elle peut présenter une épaisseur comprise entre quelques dizaines et quelques centaines de nanomètres, par exemple comprise entre 10nm et 500nm, de préférence comprise entre 10nm et 30nm.

Le microbolomètre 10 comporte une membrane absorbante 11 intégrant un matériau sensible 15 à base d'oxyde de vanadium VOₓ, suspendue au-dessus du substrat 2 par des piliers d'ancrage 12 et des bras d'isolation thermique 13. Les piliers d'ancrage 12 sont électriquement conducteurs, et traversent localement la couche de protection pour assurer un contact électrique avec le circuit électronique. La membrane absorbante 11 est espacée du substrat 2, et en particulier de la couche réflectrice 14, d'une distance non nulle. Cette distance est de préférence ajustée de manière à former une cavité quart d'onde optimisant l'absorption du rayonnement électromagnétique à détecter par la membrane suspendue 11.

Comme l'illustre la fig.1B, la membrane absorbante 11 peut comporter une couche inférieure de support 20 réalisée en un matériau électriquement isolant sur laquelle reposent deux électrodes 21.1, 21.2 distinctes l'une de l'autre, réalisées par exemple en TiN qui présente une forte absorption du rayonnement infrarouge. Une couche mince du matériau sensible 15 repose sur la couche support 20 et vient au contact de chacune des deux électrodes 21.1, 21.2. Le matériau sensible 15 est ici recouvert d'une couche de protection 22, réalisée par exemple en un nitrure de silicium SiN ou un oxyde de silicium SiO, laquelle permet d'éviter toute contamination ultérieure du matériau sensible 15. Cet exemple est donné à titre purement illustratif et d'autres agencements des électrodes et du matériau sensible sont possibles.

Par ailleurs, le microbolomètre 10 peut être situé dans une cavité hermétique définie par une structure d'encapsulation (non représentée), comme le décrit notamment la publication de Dumont et al. intitulé Current progress on pixel level packaging for uncooled IRFPA, SPIE Proceedings Vol.8353 (2012). La structure d'encapsulation peut être formée d'un empilement de différentes couches minces, telles qu'une couche d'encapsulation par exemple réalisée en silicium amorphe déposé par CVD ou iPVD, recouverte d'une couche de scellement et d'antireflet, par exemple réalisée en différentes sous-couches de germanium et de sulfure de zinc, déposées par exemple par EBPVD, IBS ou autre. Une telle structure d'encapsulation est notamment décrite dans la demande de brevet EP3067675.

Le matériau sensible 15 est à base d'oxyde de vanadium VOₓ, c'est-à-dire qu'il est formé d'un 'composé de base' réalisé à partir d'un oxyde de vanadium VOₓ dans lequel a été ajouté un élément chimique additionnel choisi parmi l'arsenic, le germanium, le silicium, et le phosphore à l'exception de l'azote. Le matériau sensible 15 ne comporte donc pas d'azote : la quantité d'azote dans le matériau sensible 15 est donc nulle ou quasi-nulle, c'est-à-dire est inférieure ou égale à 0.1% en proportion atomique. Un élément chimique additionnel est un élément chimique ajouté volontairement au composé de base qu'est l'oxyde de vanadium. Le matériau sensible 15 est amorphe, c'est-à-dire qu'il ne contient sensiblement pas de phases cristallines. Par ailleurs, il présente une résistivité électrique comprise entre 0.1 Ω.cm et 30 Ω.cm, ce qui correspond par exemple à une quantité d'oxygène x, définie comme le rapport entre le nombre d'atomes d'oxygène sur le nombre d'atomes de vanadium, comprise entre 1.42 et 1.94 à plus ou moins 0.05 près. Plus précisément, le composé de base présente une résistivité électrique comprise entre 1 Ω.cm et 30 Ω.cm. Le composé modifié, correspondant au composé de base dans lequel a été ajouté l'élément chimique additionnel présente une résistivité électrique comprise entre 0.1 Ω.cm et 30 Ω.cm. La quantité x d'oxygène est identique dans le composé de base et le composé modifié. De plus, il présente une composition chimique homogène, c'est-à-dire que sa composition chimique telle qu'elle est définie dans un volume élémentaire de l'ordre de 3nm de diamètre est invariante à grande échelle (dans au moins 90%, 95%, voire 99% de son volume).

Le composé de base est amorphe et est réalisé à base de VOₓ avec x compris entre 1.42 et 1.94, à plus ou moins 0.05 près, et de préférence compris entre 1.56 et 1.94, à 0.05 près. Il ne présente pas une forme stoechiométrique. Il se distingue ainsi des composés stoechiométriques du type VO₂, le V₂O₅, le V₃O₅. Comme précisé précédemment, le composé de formule chimique brute V₂O₅ comporte ici 5 atomes d'oxygène pour 2 atomes de vanadium (x=5/2), et le composé V₃O₅ comporte 5 atomes d'oxygène pour 3 atomes de vanadium (x=5/3). Notons ici que le composé stoechiométrique V₃O₅ est un composé qui ne peut être obtenu dans les conditions de réalisation usuelles d'un tel composé de base VOₓ de microbolomètre (température habituellement inférieure au budget thermique maximal du circuit de lecture situé dans le substrat 2, i.e. inférieure à 400°C). Aussi, le matériau sensible VOₓ selon l'invention peut présenter une quantité x égale à 1.67 sans pour autant qu'il corresponde à la forme stoechiométrique V₃O₅. Par ailleurs, en ce qui concerne le composé stoechiométrique V₂O₃, la probabilité est quasi nulle qu'un tel composé de base, c'est-à-dire amorphe et présentant une résistivité électrique comprise entre 1 Ω.cm et 30 Ω.cm environ, puisse former après recuit à la température Tᵣ une unique phase cristalline stoechiométrique V₂O₃. Aussi, même pour un composé de base amorphe ayant une quantité d'oxygène à 1.5 environ, donc à 0.05 près, plusieurs phases cristallines stoechiométriques différentes par leur quantité d'oxygène sont donc susceptibles d'être formées après recuit à Tᵣ, dont la phase cristalline V₂O₃. Quoi qu'il en soit, dans le cas où la quantité d'oxygène du composé de base amorphe est comprise entre 1.56 et 1.94, à 0.05 près, une unique phase cristalline stoechiométrique V₂O₃ ne peut se former après recuit à Tᵣ. Notons par ailleurs que, dans le cas où le composé de base ou le matériau sensible présente une quantité d'oxygène x comprise entre 1.56 et 1.94, à 0.05 près, la résistivité électrique native est alors comprise entre 2 Ω.cm et 30 Ω.cm environ.

Le matériau sensible 15 correspond alors à un composé modifié, c'est-à-dire qu'il correspond au composé de base qui a été modifié par l'addition d'au moins un élément chimique additionnel choisi parmi l'arsenic As, le germanium Ge, le silicium Si et le phosphore P. Comme détaillé plus loin, il est de préférence choisi parmi l'arsenic, le germanium et le silicium, et est de préférence l'arsenic.

La quantité d'élément chimique additionnel, à savoir le nombre d'atomes d'arsenic As, de germanium Ge, de silicium Si ou de phosphore P, sur celui de vanadium, est choisie de manière à conférer au matériau sensible, lequel a été exposé à la température Tᵣ pendant la durée Δtᵣ, une stabilité thermique améliorée, plus précisément une résistivité électrique ρ_{a|r} à température ambiante supérieure à 10% de sa valeur native ρₐ, et de préférence supérieure ou égale à 50% de sa valeur native. Par au moins égal, on entend supérieur ou égal. La valeur native ρₐ de la résistivité électrique est celle du matériau sensible avant qu'il ait été exposé à la température Tᵣ pendant Δtᵣ.

Les valeurs de la température Tᵣ et de la durée Δtᵣ sont telles que le premier composé à base de VOₓ (donc sans l'élément chimique additionnel) présente une résistivité électrique à température ambiante inférieure ou égale à 10% de sa valeur native. Il s'agit de valeurs de température et de durée de l'exposition thermique à laquelle le matériau sensible 15 sera susceptible d'être soumis lors des étapes ultérieures de fabrication du microbolomètre.

La quantité d'élément chimique additionnel (As, Ge, Si et/ou P) est alors supérieure ou égale à une valeur dite efficace, dite quantité efficace. La quantité efficace est la quantité minimale, non nulle, de l'élément chimique additionnel (As, Ge, Si et/ou P) à partir de laquelle le matériau sensible, ayant subi une étape d'exposition à la température Tᵣ pendant la durée Δtᵣ, présente une résistivité électrique ρ_{a|r} à température ambiante, supérieure à 10% de la valeur native ρₐ dudit matériau sensible à température ambiante, et de préférence supérieure ou égale à 50% de la valeur native ρₐ. La température ambiante peut être égale à 30°C. La température Tᵣ est supérieure à la température ambiante, et est de préférence supérieure ou égale à 330°C, et de préférence supérieure ou égale à 350°C. Elle peut être inférieure ou égale à 400°C. La durée Δtᵣ est de préférence supérieure ou égale à quelques minutes ou dizaines de minutes, voire à quelques heures.

Autrement dit, lorsque le matériau sensible, dont la quantité de l'élément chimique additionnel (As, Ge, Si et/ou P) est supérieure ou égale à la quantité efficace, n'a pas été exposé à la température Tᵣ pendant la durée Δtᵣ, sa résistivité électrique à température ambiante présente la valeur native ρₐ. Après exposition thermique à Tᵣ pendant Δtᵣ, le matériau sensible présente alors une résistivité électrique ρ_{a|r} à température ambiante supérieure à 10% de la valeur native ρₐ et de préférence supérieure ou égale à 50% de la valeur native ρₐ.

La quantité efficace dépend notamment du composé de base considéré, ainsi que des valeurs choisies de la température Tᵣ et de la durée Δtᵣ de l'exposition thermique. L'homme du métier est à même de déterminer la quantité efficace, c'est-à-dire la quantité minimale de l'élément chimique additionnel (As, Ge, Si et/ou P), à ajouter au composé de base pour que le matériau sensible présente une résistance électrique ρ_{a|r} à température ambiante supérieure à 10% de la valeur native ρₐ. La quantité efficace peut être choisie, le cas échéant, de sorte que la valeur ρ_{a|r} soit supérieure à 10%, par exemple au moins égale à 50%, voire au moins égale à 90% de la valeur native ρₐ.

La résistivité électrique à température ambiante du matériau sensible peut être déterminée par une technique de mesure conventionnelle à quatre pointes, et la composition atomique du matériau sensible, et partant, la quantité de l'élément chimique additionnel, peut être notamment déterminée par NRA (*Nuclear réaction Analysis*), par RBS (*Rutherford Backscattering Spectroscopy*), par SIMS (*Secondary Ion Mass Spectrometry*), par XPS (*X-ray Photoelectron Spectroscopy*), en utilisant les étalons adaptés.

Il est connu que la résistivité électrique à température ambiante d'un matériau sensible constitué d'oxyde de vanadium VOₓ peut présenter une chute de sa valeur lorsqu'il a été exposé à une température de 300°C ou de 400°C, en particulier sous atmosphère inerte (sous azote), comme le décrit la publication de Venkatasubramanian et al. intitulée Corrélation of température response and structure of annealed VOx thin films for IR detector applications, J. Vac. Sci. Technol. A 27(4), 2009, 956-961. Ainsi, un matériau sensible constitué d'oxyde de vanadium, donc sans élément chimique additionnel tel que l'arsenic, le germanium, le silicium et le phosphore, présente une résistivité électrique ρ_{a|r} à température ambiante du même ordre de grandeur que sa valeur native ρₐ après exposition à une température de l'ordre de 200°C sous atmosphère inerte. Cependant, la résistivité électrique ρ_{a|r} chute d'un ordre de grandeur, voire de plusieurs ordres de grandeur, lorsque le matériau sensible a été exposé à une température de 300°C ou de 400°C pendant 10min ou 30min sous atmosphère inerte.

Cependant, les inventeurs ont constaté que l'addition d'une quantité suffisante d'un élément chimique additionnel choisi parmi l'arsenic, le germanium, le silicium et le phosphore, dans un matériau sensible à base d'oxyde de vanadium permet d'améliorer, de manière surprenante, la stabilité thermique du matériau sensible lors d'une exposition thermique à des températures élevées, par exemple de l'ordre de 330°C voire davantage, pendant plusieurs dizaines de minutes, et plus précisément de limiter voire écarter une éventuelle dégradation du bruit en 1/f du matériau sensible à la suite de l'étape d'exposition thermique.

Le matériau sensible à base d'oxyde de vanadium, avec addition d'une quantité suffisante de l'élément chimique additionnel (As, Ge, Si et/ou P), présente alors une résistivité électrique ρ_{a|r} à température ambiante supérieure à 10% de la valeur native ρₐ. La quantité effective ajouté dans le premier composé en VOₓ est une quantité supérieure ou égale à la quantité efficace déterminée. Un tel matériau sensible ne présente alors pas de dégradation significative de ses propriétés électriques, et notamment ne présente pas de dégradation significative de sa résistivité électrique à température ambiante ni de son bruit en 1/f, à la suite du procédé de fabrication du microbolomètre qui comporte au moins une étape d'exposition du matériau sensible à au plus Tᵣ pendant au plus Δtᵣ, comme des étapes de dépôt de couches minces, d'encapsulation du microbolomètre dans une cavité hermétique, voire d'activation d'un matériau getter.

Plus précisément, il apparaît qu'une exposition d'un composé à base de VOₓ, lorsqu'il est amorphe et présente une résistivité électrique native ρₐ à température ambiante comprise entre 1 Ω.cm et 30 Ω.cm, à une température Tᵣ pendant une durée Δtᵣ telles que sa résistivité électrique ρ_{a|r} est au moins inférieure à 50% de sa valeur native ρₐ, provoque également une dégradation du bruit en 1/f, sans pour autant que le coefficient TCR soit affecté. Rappelons que le bruit en 1/f, également appelé bruit de flicker ou bruit basse fréquence, provient notamment des fluctuations de mobilité et/ou de densité des porteurs libres.

Par ailleurs, un composé amorphe à base d'un oxyde de vanadium VOₓ, pour lequel la résistivité électrique est comprise entre 1 Ω.cm et 30 Ω.cm, n'est pas susceptible de former une phase cristalline stoechiométrique unique, après recuit à Tᵣ, dans les conditions usuelles de réalisation d'un tel composé de base VOₓ d'un microbolomètre (température inférieure à 400°C). Dans une telle gamme de résistivité électrique, le composé de base présente une quantité d'oxygène x de l'ordre de 1.42 à 1.94 environ. Par environ, on entend ici que l'incertitude absolue est de ±0.05. Comme indiqué précédemment, la résistivité électrique du composé de base peut être comprise entre 2 Ω.cm et 30 Ω.cm, sa quantité d'oxygène x étant alors comprise entre 1.56 et 1.94, à 0.05 près.

Les inventeurs ont constaté que l'évolution du bruit en 1/f d'un tel composé de base en fonction de la température Tᵣ d'exposition thermique pour une durée Δtᵣ donnée est corrélée à celle de la résistivité électrique, mais ne l'est pas à celle du coefficient TCR.

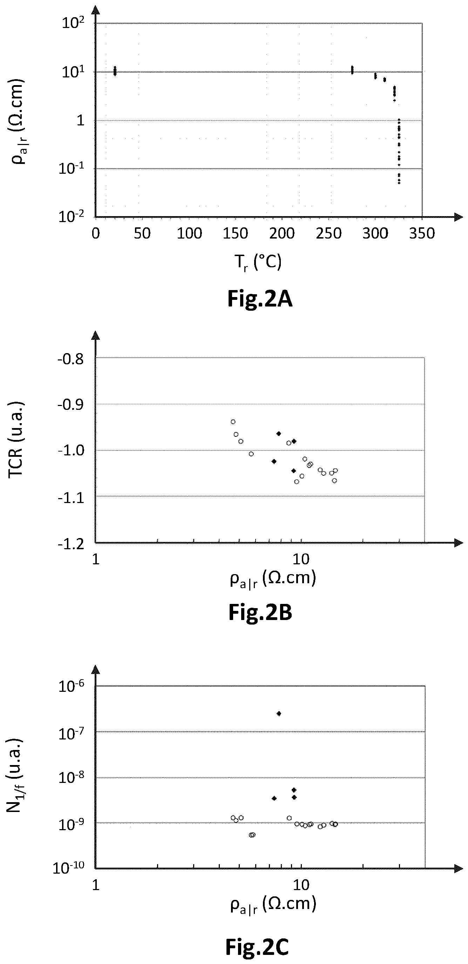

Ainsi, la figure 2A illustre un exemple d'évolution de la résistivité électrique ρ_{a|r} d'un composé de base en VO_{1.8} (ne contenant pas d'arsenic, de germanium, de silicium ni de phosphore) en fonction de la température Tᵣ pour une durée Δtᵣ égale à 90 min. Ainsi, la résistivité électrique ρ_{a|r} reste constante et égale à 10 Ω.cm environ jusqu'à la température Tᵣ de 280°C environ. Ensuite, elle présente une forte diminution, en particulier entre 300°C et 325°C.

Par ailleurs, il apparaît que, lorsque la résistivité électrique se dégrade suite à l'exposition thermique à Tᵣ pendant Δtᵣ, le coefficient thermique de résistance (TCR, pour *Température Coefficient of Résistance*, en anglais) ne subit sensiblement pas de dégradation.

Ainsi, la figure 2B illustre les valeurs de différentes mesures du coefficient TCR (en unités arbitraires) d'un composé de base en VOₓ, dont la résistivité électrique est comprise entre 5 Ω.cm et 15 Ω.cm, en fonction de la résistivité électrique ρ_{a|r} après un recuit de 310°C pendant une durée Δtᵣ de 90 min (losanges pleins). Des valeurs du coefficient TCR pour ce même type de composé de base VOₓ sans recuit à la température Tᵣ sont également indiquées (ronds vides). Il apparaît que le coefficient TCR d'un tel composé de base VOₓ reste sensiblement constant, ceci que le composé de base ait été ou non soumis à une exposition thermique de haute température Tᵣ de 310°C. Les valeurs de résistivité électrique indiquées sur la fig.2B concernant les composés de base VOₓ avec recuit (losanges pleins) correspondent à la résistivité électrique dégradée à la suite du recuit. Les valeurs natives de la résistivité électrique sont plus élevées et ne sont pas indiquées sur la figure. De plus, les valeurs de résistivité électrique concernant les composés de base VOₓ sans recuit (ronds vides) correspondent à la résistivité électrique native des composés correspondants. Les valeurs dégradées après recuit sont plus faibles mais ne sont pas indiquées sur la figure.

En revanche, il apparaît que le bruit en 1/f associé à ce type de composé de base VOₓ présente une augmentation qui est concomitante à la diminution de la résistivité électrique ρ_{a|r} lorsque celle-ci est due à l'exposition thermique à la température Tᵣ pendant la durée Δtᵣ.

Ainsi, la figure 2C illustre les valeurs de différentes mesures d'un paramètre N_{1/f} représentatif du bruit en 1/f des composés de base en VOₓ de la fig.2B en fonction de la résistivité électrique ρ_{a|r} après un recuit de 310°C pendant une durée Δtᵣ de 90 min (losanges pleins). Des valeurs de ce paramètre de bruit en 1/f pour ces composés de base VOₓ sans recuit à la température Tᵣ sont également indiquées (ronds vides). Alors que le bruit en 1/f reste sensiblement constant quelle que soit la valeur de la résistivité électrique pour ces composés de base VOₓ sans recuit à Tᵣ (ronds vides), il apparaît qu'un recuit des composés de base VOₓ à une température de 310°C pendant 90 min provoque une augmentation sensible du bruit en 1/f (losanges pleins).

Le paramètre N_{1/f} représentatif du bruit en 1/f est estimé ici à partir de l'analyse spectrale d'un courant électrique de référence qui circule dans le matériau sensible. Pour cela, on polarise le matériau sensible avec une source de tension continue (DC) réglée de manière à imposer le courant de référence dans le matériau sensible. On utilise en outre une source de tension de très faible bruit pour ne pas biaiser la mesure du bruit du matériau sensible. Ainsi le courant de référence est entaché du seul courant de bruit du matériau sensible. Ce courant est alors amplifié par un amplificateur trans-impédance qui délivre un signal de sortie en tension qui est l'image du courant d'entrée. Le signal en tension est échantillonné, numérisé et traité numériquement (transformée de Fourrier) pour obtenir son spectre. L'amplitude du bruit en 1/f peut être obtenue en relevant un point particulier du spectre, par exemple à 1 Hz ou par une méthode de calcul des moindres carrés sur la partie basse fréquence du spectre où la manifestation du bruit en 1/f est la plus marquée.

Aussi, il ressort qu'une exposition d'un composé de base VOₓ amorphe et présentant une résistivité électrique native ρₐ à température ambiante comprise entre 1 Ω.cm et 30 Ω.cm (i.e. forme non stoechiométrique), à une température Tᵣ pendant une durée Δtᵣ telles que sa résistivité électrique ρ_{a|r} chute par rapport à sa valeur native ρₐ, provoque également une dégradation du bruit en 1/f, sans pour autant que le coefficient TCR ne soit affecté.

Cette augmentation du bruit en 1/f d'un tel composé de base VOₓ peut être la conséquence d'un début de cristallisation du composé, dans laquelle des phases cristallines distinctes apparaissent, qui diffèrent entre elles par la quantité d'oxygène, ces phases cristallines étant alors des formes stoechiométriques. Ainsi, à titre d'exemple, la cristallisation au moins partielle d'un composé de base VOₓ initialement amorphe avec x de l'ordre de 1.8 se traduit par l'apparition de différentes phases cristallines stoechiométriques, parmi lesquelles VO₂ et V₂O₅ (i.e. x=2.5). L'augmentation du bruit en 1/f pourrait ainsi être lié à l'apparition de plusieurs phases cristallines stoechiométriques, différentes entre elles par la quantité d'oxygène, et donc par la perte du caractère homogène de la composition chimique du matériau sensible, et donc de ses propriétés électriques locales.

A ce titre, les figures 3A et 3B illustrent des exemples de spectres Raman d'un composé de base VOx (donc sans As, Ge, Si ou P ajouté), initialement amorphe, avec x égal à 1.85 environ, pour différentes expositions à une température Tᵣ pendant une durée Δtᵣ de 90min. Les spectres Raman de la figure 3A sont centrés sur une gamme de déplacement Raman (*Raman shift*, en anglais) allant de 100 à 300 cm⁻¹ environ, et ceux de la figure 3B le sont sur une gamme de déplacement Raman allant de 700 à 950 cm⁻¹ environ. La courbe Aₒ correspond au spectre Raman d'un composé VO_{1.85} sans recuit, et la courbe Aₛ à celle du support sur lequel repose le composé en question. Les courbes A₁, A₂, A₃ et A₄ correspondent au spectre Raman du composé VO_{1.85} ayant subi une exposition pendant 90min aux températures Tᵣ de 300°C, 310°C, 320°C et 330°C, respectivement. Il apparaît que le pic à 149 cm⁻¹ apparaît et augmente en intensité lorsque la température Tᵣ augmente, ce pic étant associé à la phase cristalline stoechiométrique V₂O₅ (x=2.5). De même, les pics à 197 cm⁻¹ et 224 cm⁻¹ associés à la phase cristalline stoechiométrique VO₂ apparaissent et augmente en intensité avec la température Tᵣ. Corrélativement, le pic à 860 cm⁻¹ associé au caractère amorphe du composé de base diminue à mesure que la température Tᵣ augmente.

Ainsi, il apparaît que l'exposition à haute température d'un composé de base réalisé à partir de VOₓ et ne contenant pas d'arsenic, de germanium, de silicium ni de phosphore, initialement amorphe, et dont la résistivité électrique native est comprise entre 1Ω.cm et 30 Ω.cm conduit à une cristallisation au moins partielle du matériau sensible, qui se traduit par une chute de sa résistivité électrique et par une augmentation du bruit en 1/f. Autrement dit, la résistivité électrique à température ambiante est un paramètre représentatif du caractère amorphe ou non du composé, ainsi que du bruit en 1/f. Aussi, par le fait d'ajouter une quantité suffisante d'arsenic, germanium, de silicium ou de phosphore comme élément chimique additionnel dans le composé de base (ou 'premier composé') pour obtenir un composé modifié, il est possible de limiter la cristallisation voire de repousser le seuil de cristallisation du composé modifié, et donc de limiter voire écarter la dégradation du bruit en 1/f.

Comme mentionné précédemment, le procédé de fabrication comporte alors une étape d'ajout dans le composé de base d'un élément chimique additionnel choisi parmi l'arsenic, le germanium, le silicium et le phosphore, de manière à obtenir un composé modifié. La résistivité électrique native est comprise entre 0.1 Ω.cm et 30 Ω.cm, ce qui correspond à une quantité d'oxygène x non stoechiométrique. La quantité d'oxygène x du composé de base n'a pas été modifiée par l'ajout de l'élément chimique additionnel. Ainsi, dans le cas où l'élément chimique additionnel est de l'arsenic, on détermine la quantité d'arsenic à ajouter dans le composé de base de sorte que le composé ainsi modifié, lorsqu'il est exposé à la température Tᵣ pendant la durée Δtᵣ déterminées préalablement, présente une résistivité électrique ρ_{a|r} supérieure ou égale à 10% de sa valeur native. Ainsi, on limite la cristallisation partielle du composé modifié faisant apparaître des phases cristallines stoechiométriques différentes entre elles par la quantité d'oxygène x, et on limite également la dégradation du bruit en 1/f. Ainsi, on améliore la stabilité thermique des propriétés du matériau sensible lorsqu'il sera ultérieurement exposé à la température Tᵣ pendant la durée Δtᵣ.

Un tel matériau sensible est alors particulièrement avantageux dans le cadre d'un procédé de fabrication collective d'une matrice de microbolomètres d'un dispositif de détection du rayonnement électromagnétique. En effet, lors d'une étape d'exposition thermique, le champ de température peut présenter des inhomogénéités spatiales au sein d'un réacteur de dépôt de couches minces ou d'un four de recuit, ce qui peut se traduire par une dispersion des propriétés électriques des microbolomètres. Ainsi, par l'utilisation du matériau sensible à quantité suffisante d'arsenic, de germanium, de silicium et/ou de phosphore, les microbolomètres présentent une meilleure stabilité thermique lors de l'exposition thermique à la température Tᵣ, réduisant ainsi la dispersion des propriétés électriques des microbolomètres.

Par ailleurs, le matériau sensible peut comporter en outre un métal de transition appartenant à la période 4 du tableau périodique des éléments, c'est-à-dire du scandium Sc, du titane Ti, du chrome Cr, du manganèse Mn, du fer Fe, du cobalt Co, du nickel Ni, du cuivre Cu et/ou du zinc Zn. Il peut également comporter d'autres éléments chimiques, par exemple l'yttrium Y, le niobium Nb, le molybdène Mo, le tantale Ta, le tungstène W, entre autres.

La figure 4A illustre des exemples d'évolution de la résistivité électrique ρ_{a|r} à température ambiante du matériau sensible en fonction de la température Tᵣ d'exposition thermique, pour différentes quantités d'arsenic As ajouté au premier composé VOₓ pour une durée Δtᵣ de 90min. Ces exemples mettent en évidence une amélioration de la stabilité thermique du matériau sensible lorsqu'il comporte la quantité efficace d'arsenic.

Dans ces exemples, les échantillons du composé modifié VOₓAs_{y} du matériau sensible ont été réalisés par une technique de dépôt du premier composé VOₓ par pulvérisation par faisceau d'ions (IBS, pour *Ion Beam Sputtering* en anglais), par exemple en pulvérisant une cible de vanadium sous atmosphère oxydante à une pression partielle d'oxygène par exemple de l'ordre de 10⁻⁴ Torr environ, suivie d'une implantation d'arsenic dans le premier composé VOₓ. On obtient ainsi le composé modifié VOₓAs_{y}. D'autres techniques de réalisation du composé modifié VOₓAs_{y} peuvent être utilisées. La résistivité électrique ρ_{a|r} du matériau sensible est mesurée à température ambiante, ici à 30°C, après exposition du matériau sensible pendant 90min à des températures de 270°C, 310°C, 330°C, 350°C, 370°C et 390°C. Différentes quantités y d'arsenic ont été ajoutées, à savoir ici 0.004, 0.012, 0.04 et 0.12. Dans ces exemples, la quantité x d'oxygène est égale à 1.9 à 0.14 près, et le premier composé VO_{1.9} présente une résistivité native de 20 Ω.cm environ.

Il apparaît que, pour la quantité y d'arsenic de 0.004, la résistivité électrique ρ_{a|r} présente une chute d'un rapport 10 par rapport à sa résistivité native ρₐ à partir d'une première température seuil T_{th,1} égale à 330°C environ. Autrement dit, la résistivité électrique ρ_{a|r} est inférieure ou égale à 10% de la valeur native ρₐ pour y = 0.004.

En revanche, il apparaît que, pour les quantités y d'arsenic de 0.012, 0.04 et 0.12, à cette température T_{th,1} égale à 330°C, la résistivité électrique ρ_{a|r} est supérieure à 10% de la résistivité native ρₐ respective. Aussi, à partir de y=0.012 d'arsenic, qui est alors la quantité efficace, le matériau sensible présente une meilleure stabilité thermique. Plus précisément :
- En ce qui concerne les quantités y d'arsenic égales à 0.012 et 0.04, il apparaît que la résistivité électrique présente une chute d'un rapport 10 par rapport aux résistivités natives ρₐ respectives à partir d'une deuxième température seuil T_{th,2} égale à 360°C environ. Il en ressort donc qu'ajouter une quantité d'arsenic au moins égale à 0.012 au composé de base VOₓ confère au moins 30°C environ de stabilité thermique supplémentaire au matériau sensible.
- En ce qui concerne la quantité y d'arsenic égale à 0.12, il apparaît que, jusqu'à au moins 390°C, la résistivité électrique ne présente pas de chute d'un rapport 10 par rapport à sa résistivité native ρₐ. Aussi, ajouter une quantité d'arsenic au moins égale à 0.12 confère au moins 60°C environ de stabilité thermique supplémentaire au matériau sensible.

Notons enfin que l'ajout dans le composé de base VOₓ d'une quantité d'arsenic allant jusqu'à 0.12 conduit à une diminution au plus d'un rapport 60 environ de la résistivité électrique native du composé modifié VOₓAs_{y≤0.12} par rapport à la résistivité native de 20 Ω.cm du composé de base VO_{1.9}. On passe ainsi d'une résistivité électrique native de 20 Ω.cm pour VO_{1.9} à 0.49 Ω.cm pour VO_{1.9}As_{0.12}. De plus, pour une température Tᵣ comprise entre la température ambiante et 390°C, la résistivité électrique ρ_{a|r} d'un composé modifié VO_{1.9}As_{0.12} reste supérieure ou égale à 0.18 Ω.cm.

Il en ressort donc qu'une quantité y d'arsenic supérieure ou égale à 0.012, et de préférence supérieure ou égale à 0.12, confère au matériau sensible une plus grande stabilité thermique, en termes de résistivité électrique et donc en termes de bruit en 1/f. La stabilité thermique est ici améliorée de 30°C lorsque y est égal à 0.012 et 0.04, et d'au moins 60°C dans le cas où y=0.12. De plus, il est avantageux que l'élément chimique additionnel soit l'arsenic dans la mesure où il conduit à limiter la diminution de la résistivité électrique du matériau sensible vis-à-vis de celle du composé de base VO_{1.9}.

Enfin, il apparaît que le composé modifié VOₓAs_{0.12} présente une variation relative particulièrement faible de la résistivité électrique ρ_{a|r} en fonction de la température Tᵣ, jusqu'à au moins 390°C. Cela permet alors de limiter la dispersion de propriétés électriques des microbolomètres issue d'éventuelles inhomogénéités spatiales du champ de température au sein du réacteur de dépôt ou du four de recuit.

La figure 4B illustre des exemples d'évolution de la résistivité électrique ρ_{a|r} à température ambiante du matériau sensible en fonction de la température Tᵣ d'exposition thermique, pour différentes quantités de germanium Ge ajouté au premier composé VOₓ pour une durée Δtᵣ de 90min. Ces exemples mettent en évidence une amélioration de la stabilité thermique du matériau sensible lorsqu'il comporte la quantité efficace de germanium.

Dans ces exemples, les échantillons du matériau sensible VOₓGe_{y} est obtenu de manière similaire à celle décrite précédemment, c'est-à-dire par implantation de germanium dans un matériau VOₓ obtenu préalablement par pulvérisation IBS. La quantité x d'oxygène est ici égale à 1.9 à 0.14 près, ce qui correspond à une résistivité électrique native du premier composé VO_{1.9} égale à 20 Ω.cm.

Il apparaît que, pour les quantités y de germanium de 0.004 et 0.012, la résistivité électrique ρ_{a|r} présente une chute d'un rapport 10 par rapport à sa résistivité native ρₐ à partir d'une première température seuil T_{th,1} égale à 330°C environ.

En revanche, il apparaît que, pour les quantités y de germanium de 0.04 et 0.12, à cette température T_{th,1} égale à 330°C, la résistivité électrique ρ_{a|r} est supérieure à 10% de sa résistivité native ρₐ. Aussi, à partir de y=0.04 de germanium, qui est alors la quantité efficace, le matériau sensible présente une meilleure stabilité thermique. Plus précisément :
- En ce qui concerne la quantité y = 0.04 de germanium, la résistivité électrique présente une chute d'un rapport 10 par rapport aux résistivités natives ρₐ correspondantes à partir d'une deuxième température seuil T_{th,2} égale à 350°C environ. Il en ressort donc qu'ajouter une quantité de germanium au moins égale à 0.04 au composé de base VOₓ confère au moins 20°C environ de stabilité thermique supplémentaire au matériau sensible.
- En ce qui concerne la quantité y = 0.12 de germanium, jusqu'à au moins 390°C, la résistivité électrique ne présente pas de chute d'un rapport 10 par rapport à sa résistivité native ρₐ. Aussi, ajouter une quantité de germanium au moins égale à 0.12 confère au moins 60°C environ de stabilité thermique supplémentaire au matériau sensible.

Il en ressort donc qu'une quantité y de germanium supérieure ou égale à 0.04, et de préférence supérieure ou égale à 0.12, confère au matériau sensible une plus grande stabilité thermique, en termes de résistivité électrique et donc en termes de bruit en 1/f. La stabilité thermique est ici améliorée de 20°C pour y=0.04, et d'au moins 60°C pour y=0.12.

Enfin, il apparaît que le composé modifié VOₓGe_{0.12} présente une variation relative particulièrement faible de la résistivité électrique ρ_{a|r} en fonction de la température Tᵣ, jusqu'à au moins 390°C. Cela permet alors de limiter la dispersion de propriétés électriques des microbolomètres issue d'éventuelles inhomogénéités spatiales du champ de température au sein du réacteur de dépôt ou du four de recuit.

La figure 4C illustre des exemples d'évolution de la résistivité électrique ρ_{a|r} à température ambiante du matériau sensible en fonction de la température Tᵣ d'exposition thermique, pour différentes quantités de silicium Si ajouté au premier composé VOₓ pour une durée Δtᵣ de 90min. Ces exemples mettent en évidence une amélioration de la stabilité thermique du matériau sensible lorsqu'il comporte la quantité efficace de silicium.

Dans ces exemples, les échantillons du matériau sensible VOₓSi_{y} est obtenu de manière similaire à celle décrite précédemment, c'est-à-dire par implantation de silicium dans un matériau VOₓ obtenu préalablement par pulvérisation IBS. La quantité x d'oxygène est ici égale à 1.9 à 0.14 près, ce qui correspond à une résistivité électrique native du premier composé VO_{1.9} égale à 20 Ω.cm.

Il apparaît que, pour les quantités y de silicium de 0.004 et 0.012, la résistivité électrique ρ_{a|r} présente une chute d'un rapport 10 par rapport à sa résistivité native ρₐ à partir d'une première température seuil T_{th,1} égale à 315°C environ.

En revanche, il apparaît que, pour les quantités y de silicium de 0.04 et 0.12, à cette température T_{th,1} égale à 315°C, la résistivité électrique ρ_{a|r} est supérieure à 10% de sa résistivité native ρₐ. Aussi, à partir de y=0.04 de silicium, qui est alors la quantité efficace, le matériau sensible présente une meilleure stabilité thermique. Plus précisément :
- En ce qui concerne la quantité y = 0.04 de silicium, la résistivité électrique présente une chute d'un rapport 10 par rapport aux résistivités natives ρₐ correspondantes à partir d'une deuxième température seuil T_{th,2} égale à 350°C environ. Il en ressort donc qu'ajouter une quantité de silicium au moins égale à 0.04 au composé de base VOₓ confère au moins 35°C environ de stabilité thermique supplémentaire au matériau sensible.
- En ce qui concerne la quantité y = 0.12 de silicium, jusqu'à au moins 390°C, la résistivité électrique ne présente pas de chute d'un rapport 10 par rapport à sa résistivité native ρₐ. Aussi, ajouter une quantité de silicium au moins égale à 0.12 confère au moins 75°C environ de stabilité thermique supplémentaire au matériau sensible.

Il en ressort donc qu'une quantité y de silicium supérieure ou égale à 0.04, et de préférence supérieure ou égale à 0.12, confère au matériau sensible une plus grande stabilité thermique, en termes de résistivité électrique et donc en termes de bruit en 1/f. La stabilité thermique est ici améliorée de 35°C pour y=0.04, et d'au moins 75°C pour y=0.12.

Enfin, il apparaît que le composé modifié VOₓSi_{0.12} présente une variation relative particulièrement faible de la résistivité électrique ρ_{a|r} en fonction de la température Tᵣ, jusqu'à au moins 390°C. Cela permet alors de limiter la dispersion de propriétés électriques des microbolomètres issue d'éventuelles inhomogénéités spatiales du champ de température au sein du réacteur de dépôt ou du four de recuit.

La figure 4D illustre des exemples d'évolution de la résistivité électrique ρ_{a|r} à température ambiante du matériau sensible en fonction de la température Tᵣ d'exposition thermique, pour différentes quantités de phosphore P ajouté au premier composé VOₓ pour une durée Δtᵣ de 90min. Ces exemples mettent en évidence une amélioration de la stabilité thermique du matériau sensible lorsqu'il comporte la quantité efficace de phosphore.

Dans ces exemples, les échantillons du matériau sensible VOₓP_{y} est obtenu de manière similaire à celle décrite précédemment, c'est-à-dire par implantation de phosphore dans un matériau VOₓ obtenu préalablement par pulvérisation IBS. La quantité x d'oxygène est ici égale à 1.9 à 0.14 près, ce qui correspond à une résistivité électrique native du premier composé VO_{1.9} égale à 20 Ω.cm.

Il apparaît que, pour les quantités y de phosphore de 0.004, 0.012 et 0.04, la résistivité électrique ρ_{a|r} présente une chute d'un rapport 10 par rapport à sa résistivité native ρₐ à partir d'une première température seuil T_{th,1} égale à 320°C environ.

En revanche, il apparaît que, pour la quantité y de phosphore 0.12, à cette température T_{th,1} égale à 320°C, la résistivité électrique ρ_{a|r} est supérieure à 10% de sa résistivité native ρₐ. Aussi, à partir de y=0.12 de phosphore, qui est alors la quantité efficace, le matériau sensible présente une meilleure stabilité thermique.

Plus précisément, en ce qui concerne la quantité y = 0.12 de phosphore, la résistivité électrique présente une chute d'un rapport 10 par rapport aux résistivités natives ρₐ correspondantes à partir d'une deuxième température seuil T_{th,2} égale à 360°C environ. Il en ressort donc qu'ajouter une quantité de phosphore au moins égale à 0.12 au composé de base VOₓ confère au moins 40°C environ de stabilité thermique supplémentaire au matériau sensible, en termes de résistivité électrique et donc en termes de bruit en 1/f.

Aussi, l'élément chimique additionnel est choisi parmi l'arsenic, le germanium, le silicium, et le phosphore. Cependant, il est de préférence choisi parmi l'arsenic, le germanium, et le silicium, dans la mesure où ces trois éléments chimiques permettent d'augmenter la stabilité thermique du matériau sensible à au moins 390°C, ce qui n'est pas le cas avec le phosphore. Ceci est d'autant plus surprenant que ces quatre éléments chimiques font partie, avec le bore, des éléments chimiques formateurs de réseau vitreux, c'est-à-dire qu'ils font partie des éléments chimiques dont un oxyde peut former à lui seul (sans autre ajout) un matériau amorphe stable. Les oxydes des formateurs de réseau sont SiO₂ pour le silicium, P₂O₅ pour le phosphore, GeO₂ pour le germanium, et As₂O₃ pour l'arsenic. Or, il est surprenant que, parmi cette famille des formateurs de réseau, l'arsenic, le germanium et le silicium permettent d'obtenir une meilleure stabilité thermique que le phosphore. D'ailleurs, on pourrait penser que le silicium et le phosphore seraient des éléments chimiques tout aussi efficaces l'un que l'autre dans la mesure où ils sont, comme le bore, des ions de plus petite taille que l'arsenic et le germanium. Or, il apparaît que, de manière surprenante, le phosphore est moins efficace que le silicium. Aussi, l'élément chimique additionnel est de préférence choisi parmi l'arsenic, le germanium, et le silicium.

Des modes de réalisation particuliers viennent d'être décrits. Différentes variantes et modifications apparaîtront à l'homme du métier.

## Revendications

1. Procédé de fabrication d'au moins un microbolomètre (10) comportant un matériau sensible (15), le procédé permettant de limiter une dégradation d'un bruit associé audit matériau sensible (15),
∘ ledit matériau sensible (15) étant formé : d'un premier composé à base d'oxyde de vanadium (VOₓ) ; et d'au moins un élément chimique additionnel ajouté audit premier composé et choisi parmi l'arsenic (As), le germanium (Ge), le silicium (Si), et le phosphore (P), à l'exception de l'azote (N),
∘ le procédé comportant les étapes suivantes :
• une étape de réalisation dudit matériau sensible (15) en couche mince ;
• une étape d'exposition du matériau sensible (15) à une température Tᵣ supérieure à la température ambiante pendant une durée Δtᵣ, effectuée ultérieurement à l'étape de réalisation du matériau sensible (15),
- la température Tᵣ et la durée Δtᵣ étant telles que ledit premier composé, étant amorphe et présentant une valeur native de résistivité électrique à température ambiante comprise entre 1 Ω.cm et 30 Ω.cm, ayant subi une étape d'exposition à la température Tᵣ pendant la durée Δtᵣ, présente une résistivité électrique à température ambiante inférieure ou égale à 10% de sa valeur native ;
∘ le procédé comportant en outre les étapes suivantes :
• détermination d'une quantité dite efficace non nulle de l'élément chimique additionnel (As, Ge, Si, P) ajouté audit premier composé (VOₓ), formant ainsi un composé modifié, à partir de laquelle le composé modifié, ayant subi une étape d'exposition à la température Tᵣ pendant la durée Δtᵣ, présente une résistivité électrique ρ_{a|r} à température ambiante supérieure à 10% de sa valeur native ρₐ ;
• lors de ladite étape de réalisation du matériau sensible (15) en couche mince, celui-ci est formé dudit composé modifié ayant une quantité de l'élément chimique additionnel (As, Ge, Si, P) supérieure ou égale à la quantité efficace préalablement déterminée, le matériau sensible (15) étant amorphe, présentant une valeur native ρₐ de résistivité électrique à température ambiante comprise entre 0.1 Ω.cm et 30 Ω.cm ainsi qu'une composition chimique homogène ;
• de sorte que, à la suite de ladite étape d'exposition du matériau sensible (15) à la température Tᵣ pendant la durée Δtᵣ, ledit matériau sensible (15) présente alors un bruit dont la dégradation a été limitée.

2. Procédé de fabrication selon la revendication 1, l'élément chimique additionnel étant choisi parmi l'arsenic, le germanium, et le silicium, et est de préférence l'arsenic.

3. Procédé de fabrication selon la revendication 1 ou 2, dans lequel l'étape d'exposition du matériau sensible (15) comprend une étape de dépôt d'une couche de protection (22) recouvrant le matériau sensible.

4. Procédé de fabrication selon l'une quelconque des revendications 1 à 3, dans lequel l'étape d'exposition du matériau sensible (15) comprend une étape de dépôt d'une couche d'encapsulation transparente au rayonnement électromagnétique à détecter destinée à définir une cavité dans laquelle est situé le microbolomètre.

5. Procédé de fabrication selon l'une quelconque des revendications 1 à 4, dans lequel la température Tᵣ est supérieure ou égale à 330°C, voire égale à 350°C à 5°C près.

6. Procédé de fabrication selon l'une quelconque des revendications 1 à 5, dans lequel la durée Δtᵣ est supérieure ou égale à 90min.

7. Procédé de fabrication selon l'une quelconque des revendications 1 à 6, dans lequel le matériau sensible (15) est réalisé à une température inférieure à la température Tᵣ.

8. Microbolomètre (10) comportant un matériau sensible (15) amorphe et présentant une résistivité électrique à température ambiante comprise entre 0.1 Ω.cm et 30 Ω.cm, et formé : d'un premier composé à base d'oxyde de vanadium (VOₓ) ; et d'au moins un élément chimique additionnel choisi parmi l'arsenic, le germanium, le silicium et le phosphore, à l'exception de l'azote, **caractérisé en ce que** le matériau sensible (15) :
∘ présente une composition chimique homogène, et
∘ comporte une quantité de l'élément chimique additionnel, définie comme le rapport du nombre d'atomes l'élément chimique additionnel sur celui de vanadium, au moins égale à 0.012 dans le cas de l'arsenic, au moins égale à 0.04 dans le cas du germanium et du silicium, et au moins égale à 0.12 dans le cas du phosphore.

9. Microbolomètre (10) selon la revendication 8, dans lequel la quantité d'oxygène, définie comme le rapport du nombre d'atomes d'oxygène sur celui de vanadium, est comprise entre 1.42 et 1.94, à plus ou moins 0.05 près.

10. Microbolomètre (10) selon la revendication 8 ou 9, dans lequel le matériau sensible (15) est recouvert par une couche de protection (22) en nitrure de silicium.

11. Dispositif de détection (1) d'un rayonnement électromagnétique, comportant une matrice de microbolomètres selon l'une quelconque des revendications 8 à 10, les microbolomètres (10) étant disposés dans au moins une cavité hermétique délimitée par une structure d'encapsulation transparente au rayonnement électromagnétique à détecter, la structure d'encapsulation comportant au moins une couche réalisée en silicium amorphe.

12. Dispositif de détection (1) selon la revendication 11, comportant un matériau getter situé dans la cavité hermétique.

## Patentansprüche

1. Verfahren zum Herstellen mindestens eines Mikrobolometers (10), das ein empfindliches Material (15) umfasst, wobei das Verfahren ein Begrenzen einer Verschlechterung eines mit dem empfindlichen Material (15) verbundenen Rauschens ermöglicht,
∘ wobei das empfindliche Material (15) aus Folgendem ausgebildet ist: einer ersten Verbindung auf Basis von Vanadiumoxid (VOₓ); und mindestens einem zusätzlichen chemischen Element, das zur ersten Verbindung hinzugefügt und aus Arsen (As), Germanium (Ge), Silizium (Si) und Phosphor (P), außer Stickstoff (N), ausgewählt wird,
∘ wobei das Verfahren die folgenden Schritte umfasst:
• einen Schritt des Herstellens des empfindlichen Materials (15) in einer dünnen Schicht;
• einen Schritt des Aussetzens des empfindlichen Materials (15) gegenüber einer Temperatur Tᵣ, die größer als die Umgebungstemperatur ist, während einer Dauer Δtᵣ, der nach dem Schritt des Herstellens des empfindlichen Materials (15) ausgeführt wird,
- wobei dieTemperatur Tᵣ und die Dauer Δtᵣ derart sind, dass die erste Verbindung, die amorph ist und einen nativen Wert für den elektrischen Widerstand bei der Umgebungstemperatur in einem Bereich von 1 Ω.m bis 30 Ω.cm aufweist, nachdem sie einem Schritt des Aussetzens gegenüber der Temperatur Tᵣ während der Dauer Δtᵣ durchlaufen hat, einen elektrischen Widerstand bei Umgebungstemperatur aufweist, der kleiner oder gleich 10 % ihres nativen Werts ist;
o wobei das Verfahren ferner die folgenden Schritte umfasst:
• Bestimmen einer wirksamen Menge ungleich Null des zusätzlichen chemischen Elements (As, Ge, Si, P), die der ersten Verbindung (VOₓ) hinzugefügt wird, wodurch eine modifizierte Verbindung gebildet wird, ausgehend von der die modifizierte Verbindung, nachdem sie einem Schritt des Aussetzens gegenüber der Temperatur Tᵣ während der Dauer Δtᵣ durchlaufen hat, einen elektrischen Widerstand ρ_{a|r} bei Umgebungstemperatur aufweist, der kleiner oder gleich 10 % ihres nativen Werts ρₐ ist;
• wobei beim Schritt des Herstellens des empfindlichen Materials (15) in einer dünnen Schicht diese aus der modifizierten Verbindung ausgebildet wird, die eine Menge des zusätzlichen chemischen Elements (As, Ge, Si, P) aufweist, die größer oder gleich der zuvor bestimmten wirksamen Menge ist, wobei das empfindliche Material (15) amorph ist, einen nativen Wert für den elektrischen Widerstand bei der Umgebungstemperatur in einem Bereich von 0,1 Ω.m bis 30 Ω.cm sowie eine homogene chemische Zusammensetzung aufweist;
• so dass das empfindliche Material (15) somit nach dem Schritt des Aussetzens des empfindlichen Materials (15) gegenüber der Temperatur Tᵣ während der Dauer Δtᵣ ein Rauschen aufweist, dessen Verschlechterung begrenzt worden ist.

2. Herstellungsverfahren nach Anspruch 1, wobei das zusätzliche chemische Element aus Arsen, Germanium und Silizium ausgewählt ist und vorzugsweise Arsen ist.

3. Herstellungsverfahren nach Anspruch 1 oder 2, wobei der Schritt des Aussetzens des empfindlichen Materials (15) einen Schritt des Aufbringens einer Schutzschicht (22) umfasst, die das empfindliche Material bedeckt.

4. Herstellungsverfahren nach einem der Ansprüche 1 bis 3, wobei der Schritt des Aussetzens des empfindlichen Materials (15) einen Schritt des Aufbringens einer Einkapselungsschicht umfasst, die für die zu detektierende elektromagnetische Strahlung transparent und dazu bestimmt ist, einen Hohlraum zu definieren, in dem sich das Mikrobolometer befindet.

5. Herstellungsverfahren nach einem der Ansprüche 1 bis 4, wobei die Temperatur Tᵣ größer oder gleich 330 °C ist oder sogar bis auf 5 °C genau gleich 350 °C beträgt.

6. Herstellungsverfahren nach einem der Ansprüche 1 bis 5, wobei die Dauer Δtᵣ größer oder gleich 90 Minuten ist.

7. Herstellungsverfahren nach einem der Ansprüche 1 bis 6, wobei das empfindliche Material (15) bei einer Temperatur hergestellt wird, die kleiner als die Temperatur Tᵣ ist.

8. Mikrobolometer (10), das ein empfindliches Material (15) umfasst, das amorph ist und einen elektrischen Widerstand bei der Umgebungstemperatur zwischen 0,1 Ω.m und 30 Ω.cm aufweist und aus Folgendem ausgebildet ist: einer ersten Verbindung auf Basis von Vanadiumoxid (VOₓ); und mindestens einem zusätzlichen chemischen Element, das aus Arsen, Germanium, Silizium und Phosphor, außer Stickstoff, ausgewählt wird, **dadurch gekennzeichnet, dass** das empfindliche Material (15):
∘ eine homogene chemische Zusammensetzung aufweist, und
∘ eine Menge des zusätzlichen chemischen Elements umfasst, die als ein Verhältnis einer Anzahl von Atomen des zusätzlichen chemischen Elements zu der von Vanadium, mindestens 0,012 im Fall von Arsen, mindestens 0,04 im Fall von Germanium und Silizium und mindestens 0,12 im Fall von Phosphor, definiert ist.

9. Mikrobolometer (10) nach Anspruch 8, wobei die Sauerstoffmenge, die als Verhältnis einer Anzahl von Atomen von Sauerstoff zu der von Vanadium definiert ist, zwischen 1,42 und 1,94, bis auf plus/minus 0,05 genau, beträgt.

10. Mikrobolometer (10) nach Anspruch 8 oder 9, wobei das empfindliche Material (15) von einer Schutzschicht (22) aus Siliziumnitrid bedeckt ist.

11. Detektionsvorrichtung (1) für eine elektromagnetische Strahlung, umfassend eine Anordnung von Mikrobolometern nach einem der Ansprüche 8 bis 10, wobei die Mikrobolometer (10) in mindestens einem hermetischen Hohlraum angeordnet sind, der durch eine Einkapselungsstruktur begrenzt ist, die für die zu detektierende elektromagnetische Strahlung transparent ist, wobei die Einkapselungsstruktur eine aus amorphem Silizium hergestellte Schicht umfasst.

12. Detektionsvorrichtung (1) nach Anspruch 11, umfassend ein Gettermaterial, das sich im hermetischen Hohlraum befindet.

## Claims

1. Method for manufacturing at least one microbolometer (10) including a sensitive material (15), the method making it possible to limit degradation of a noise associated with said sensitive material (15),
∘ said sensitive material (15) being formed by: a first compound based on vanadium oxide (VOₓ); and at least one additional chemical element added to said first compound and selected from arsenic (As), germanium (Ge), silicon (Si) and phosphorus (P), with the exception of nitrogen (N),
∘ the method including the following steps:
• a step of producing said sensitive material (15) in a thin layer;
• a step of exposing the sensitive material (15) to a temperature Tᵣ higher than ambient temperature for a period Δtᵣ, implemented subsequently to the step of producing the sensitive material (15),
- the temperature Tᵣ and the period Δtᵣ being such that said first compound, being amorphous and having a native electrical resistivity value at ambient temperature of between 1 Ω.cm and 30 Ω.cm, having undergone a step of exposure to the temperature Tᵣ for the period Δtᵣ, has an electrical resistivity at ambient temperature of less than or equal to 10% of its native value;
o the method furthermore including the following steps:
• determining a so-called effective non-zero quantity of the additional chemical element (As, Ge, Si, P) added to said first compound (VOₓ), thus forming a modified compound, from which the modified compound, having undergone a step of exposure to the temperature Tᵣ for the period Δtᵣ, has an electrical resistivity ρ_{a|r} at ambient temperature greater than 10% of its native value ρₐ;
• during said step of producing the sensitive material (15) in a thin layer, the latter is formed from said modified compound having a quantity of the additional chemical element (As, Ge, Si, P) greater than or equal to the previously determined effective quantity, the sensitive material (15) being amorphous, having a native electrical resistivity value ρₐ at ambient temperature of between 0.1 Ω.cm and 30 Ω.cm as well as a homogeneous chemical composition;
• so that, following said step of exposure of the sensitive material (15) to the temperature Tᵣ for the period Δtᵣ, said sensitive material (15) then has a noise the degradation of which has been limited.

2. Manufacturing method according to claim 1, the additional chemical element being selected from arsenic, germanium and silicon, and is preferably arsenic.

3. Manufacturing method according to claim 1 or 2, wherein the step of exposing the sensitive material (15) comprises a step of depositing a protective layer (22) covering the sensitive material.

4. Manufacturing method according to any one of claims 1 to 3, wherein the step of exposing the sensitive material (15) comprises a step of depositing an encapsulation layer transparent to the electromagnetic radiation to be detected, intended to define a cavity in which the microbolometer is located.

5. Manufacturing method according to any one of claims 1 to 4, wherein the temperature Tᵣ is greater than or equal to 330°C, or even equal to 350°C to within 5°C.

6. Manufacturing method according to any one of claims 1 to 5, wherein the period Δtᵣ is greater than or equal to 90 min.

7. Manufacturing method according to any one of claims 1 to 6, wherein the sensitive material (15) is produced at a temperature below the temperature Tᵣ.

8. Microbolometer (10) including an amorphous sensitive material (15) and having an electrical resistivity at ambient temperature of between 0.1 Ω.cm and 30 Ω.cm, and formed from: a first compound based on vanadium oxide (VOₓ); and at least one additional chemical element selected from arsenic, germanium, silicon and phosphorus, with the exception of nitrogen, **characterised in that** the sensitive material (15):
∘ has a homogeneous chemical composition, and
∘ includes a quantity of the additional chemical element, defined as the ratio of the number of atoms of the additional chemical element to that of vanadium, at least equal to 0.012 in the case of arsenic, at least equal to 0.04 in the case of germanium and silicon, and at least equal to 0.12 in the case of phosphorus.

9. Microbolometer (10) according to claim 8, wherein the quantity of oxygen, defined as the ratio of the number of atoms of oxygen to that of vanadium, is between 1.42 and 1.94, to within plus or minus 0.05.

10. Microbolometer (10) according to claim 8 or 9, wherein the sensitive material (15) is covered by a protective layer (22) of silicon nitride.

11. Device (1) for detecting electromagnetic radiation, including a matrix of microbolometers according to any one of claims 8 to 10, the microbolometers (10) being disposed in at least one hermetic cavity delimited by an encapsulation structure transparent to the electromagnetic radiation to be detected, the encapsulation structure including at least one layer produced from amorphous silicon.

12. Detection device (1) according to claim 11, including a getter material located in the hermetic cavity.
